# EUROPEAN PATENT SPECIFICATION

(11) **EP 2 707 907 B1**
(45) Date of publication and mention of the grant of the patent: **30.09.2015**
(21) Application number: 12721389.0
(22) Date of filing: 04.05.2012
(51) Int. Cl.: H01L 51/42, H01L 27/30

(54) **TANDEM PHOTOVOLTAIC CELLS**
PHOTOVOLTAISCHE TANDEMZELLEN
CELLULES PHOTOVOLTAÏQUES EN TANDEM

(30) Priority: 09.05.2011 US 201161483825 P
(43) Date of publication of application: 19.03.2014
(73) Proprietor: Merck Patent GmbH, 64293 Darmstadt (DE)
(72) Inventor: BALASUBRAMANIAN, Srinivasan, Westford Massachusetts 01886 (US); CHITTIBABU, Kethinni G., Westford Massachusetts 01886 (US); ECKERT, Robert D., Lexington Massachusetts 02420 (US); GAUDIANA, Russell, Lyndeborough New Hampshire 03082 (US); KATTAMURI, Nirupama, Lowell Massachusetts 01854 (US); LEE, Michael, Billerica Massachusetts 01821 (US); WALLER, David P., Lexington Massachusetts 02420 (US)
(86) International application number: PCT/US2012/036508
(87) International publication number: WO 2012/154557

(56) References cited:
- US-A1- 2008 264 488

## Description

### TECHNICAL FIELD

This disclosure relates to tandem photovoltaic cells, as well as related systems, methods, and components.

### BACKGROUND

There is an increasing interest in the development of photovoltaic technology due primarily to a desire to reduce consumption of and dependency on fossil fuel-based energy sources. Photovoltaic technology is also viewed by many as being an environmentally friendly energy technology. However, for photovoltaic technology to be a commercially feasible energy technology, the material and manufacturing costs of a photovoltaic system (a system that uses one or more photovoltaic cells to convert light to electrical energy) should be recoverable over some reasonable time frame. But, in some instances, the cell performance and/or the costs of materials and manufacture associated with practically designed photovoltaic systems have restricted their availability and use.

### SUMMARY

This disclosure is based on the unexpected discovery that an interconnecting layer including an n-type semiconductor material (e.g., a substituted fullerene) and a cross-linked polyamine can be used to form a tandem photovoltaic cell having a large number of subcells (e.g., 10 subcells or more), while minimizing voltage loss between two neighboring subcells. As a result, the voltage output of the tandem photovoltaic cell thus formed is generally equal to the total voltages generated in the subcells.

In one aspect, this disclosure features a system that includes first and second electrodes; first and second photoactive layers between the first and second electrodes; and a recombination material between the first and second photoactive layers. The first photoactive layer is between the first electrode and the recombination material. The second photoactive layer is between the second electrode and the recombination material. The recombination material includes a first hole blocking layer and a first hole carrier layer. The first hole blocking layer includes an n-type semiconductor material and a polyamine, at least some molecules of the polyamine being cross-linked. The system is configured as a photovoltaic system.

In another aspect, this disclosure features a system that includes first and second electrodes; first and second photoactive layers between the first and second electrodes; and a recombination material between the first and second photoactive layers. The recombination material includes a first layer that comprises an n-type semiconductor material and a polyamine. The system is configured as a photovoltaic system.

In still another aspect, this disclosure features a method that includes disposing a composition containing an n-type semiconductor material, a polyamine, and a cross-linking agent on a substrate to form a layer supported by the substrate; and heating the layer to cross-link at least some molecules of the polyamine, thereby forming a first hole blocking layer.

Embodiments can include one or more of the following features.

In some embodiments, the n-type semiconductor material can include a fullerene, such as a substituted fullerene (e.g., C61-PCBM or C71-PCBM).

In some embodiments, the polyamine can be a polyethylenimine or a copolymer thereof.

In some embodiments, at least some molecules of the polyamine can be cross-linked by a cross-linking agent, such as an epoxy-containing compound (e.g., glycerol propoxylate triglycidyl ether or glycerol diglycidyl ether).

In some embodiments, the first hole blocking layer can have a thickness of from about 20 nm to about 200 nm (e.g., from about 30 nm to about 60 nm).

In some embodiments, the first hole blocking layer can have a work function of from about 3.5 eV to about 4.5 eV.

In some embodiments, the first hole carrier layer can include a p-type semiconductor material. For example, the p-type semiconductor material can include a polymer or a metal oxide. The polymer can be selected from the group consisting of polythiophenes (e.g., poly(3,4-ethylene dioxythiophene) or poly(thieno[3,4-b]thiophene)), polyanilines, polycarbazoles, polyvinylcarbazoles, polyphenylenes, polyphenylvinylenes, polysilanes, polythienylenevinylenes, polyisothianaphthanenes, and copolymers thereof. The metal oxide can include an oxide selected from the group consisting of nickel oxides, vanadium oxides, tungsten oxides, molybdenum oxides, copper oxides, strontium copper oxides, and strontium titanium oxides. In some embodiments, the p-type semiconductor material can include a metal oxide dispersed in a polymer.

In some embodiments, the first hole carrier layer can have a work function of from about 4.8 eV to about 6.5 eV.

In some embodiments, the system can further include a second hole blocking layer between the first electrode and the first photoactive layer. In such embodiments, the first photoactive layer can be between the second hole blocking layer and the first hole carrier layer. In some embodiments, the second hole blocking layer can be made from a material different from the material used to make the first hole blocking layer. For example, the second hole blocking layer can include LiF, metal oxides, or amines.

In some embodiments, the system can further include a second hole carrier layer between the second electrode and the second photoactive layer. In such embodiments, the second photoactive layer can be between the first hole blocking layer and the second hole carrier layer. For example, the second hole carrier layer can include a polymer selected from the group consisting of polythiophenes, polyanilines, polycarbazoles, polyvinylcarbazoles, polyphenylenes, polyphenylvinylenes, polysilanes, polythienylenevinylenes, polyisothianaphthanenes, and copolymers or mixtures thereof.

In some embodiments, the system can be configured as a tandem photovoltaic system.

In some embodiments, the method can further include disposing a first electrode, a first photoactive layer, and a first hole carrier layer sequentially onto the substrate prior to applying the composition to the substrate. In such embodiments, the method can further include disposing a second photoactive layer and a second electrode sequentially onto the first hole blocking layer. The method can further include disposing a second hole blocking layer on the first electrode prior to disposing the first photoactive layer and/or disposing a second hole carrier layer on the second photoactive layer prior to disposing the second electrode.

In some embodiments, each of the above disposing steps is carried out via a liquid-based coating process.

Other features, objects, and advantages of the subject matter in this disclosure will be apparent from the description and drawings, and from the claims.

### DESCRIPTION OF DRAWINGS

FIG. 1 is a cross-sectional view of an embodiment of a tandem photovoltaic cell described in this disclosure.
FIG. 2 is a schematic of a system containing multiple photovoltaic cells electrically connected in series.
FIG. 3 is a schematic of a system containing multiple photovoltaic cells electrically connected in parallel.
FIGs. 4A and 4B are graphs showing the stability of tandem photovoltaic cells described in Example 4 under light soaking conditions.
FIGs. 5A and 5B are graphs showing the stability of tandem photovoltaic cells described in Example 4 under damp heat ageing conditions.

Like reference symbols in the various drawings indicate like elements.

### DETAILED DESCRIPTION

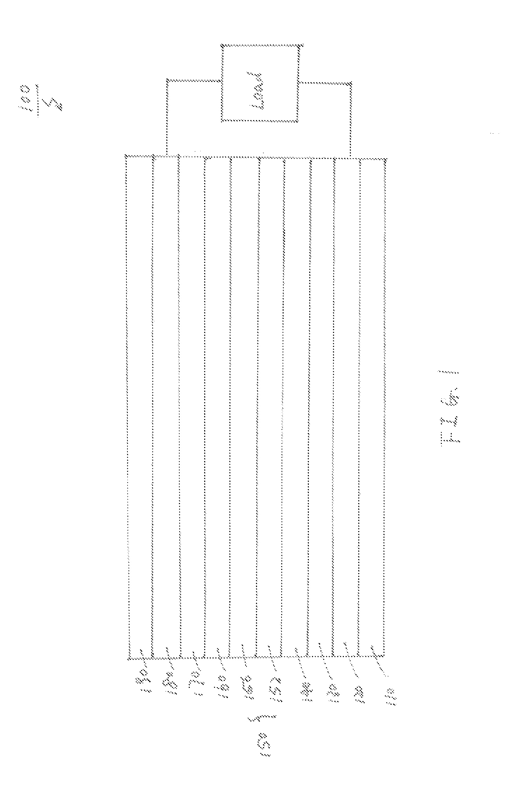

FIG. 1 shows an exemplary tandem photovoltaic cell 100 having a substrate 110, an electrode 120, an optional hole blocking layer 130, a photoactive layer 140, a recombination material 150, a photoactive layer 160, an optional hole carrier layer 170, an electrode 180, a substrate 190, an electrical connection between electrodes 120 and 180, and an external load electrically connected to photovoltaic cell 100 via electrodes 120 and 180. The recombination material 150 includes two layers, i.e., a hole carrier layer 152 and a hole blocking layer 156.

Photovoltaic cell 100 includes two subcells. The first subcell includes electrode 120, optional hole blocking layer 130, photovoltaic layer 140, and recombination material 150. The second subcellincludes recombination layer 150, photoactive layer 160, optional hole carrier layer 170, and electrode 180. The first and second subcells are electrically connected via electrodes 120 and 180 and share recombination layer 150 (which can be considered as a common electrode between the first and second subcells) such that they are electrically connected in series.

In general, during use, light can impinge on the surface of electrode 120 of the first subcell, and pass through electrode 120 and optional hole blocking layer 130. The light can then interact with photoactive layer 140. The residual light can further pass through recombination material 150, and interact with photoactive layer 160 of the second subcell. The interactions between the light and photoactive layers 120 and 160 can cause the electrons to be transferred from an electron donor material (e.g., poly(3-hexylthiophene) (P3HT)) to an electron acceptor material (e.g., C61-phenyl-butyric acid methyl ester (C61-PCBM)) within each photoactive layer. The electron acceptor materials in photoactive layers 140 and 160 can then transfer the electrons to electrode 120 and recombination material 150, respectively. The electron donor materials in photoactive layers 140 and 160 can transfer holes to recombination material 150 and electrode 180, respectively. As a result, the holes generated from the first subcellcan recombine with the electrons generated from the second subcellin recombination material 150 (e.g., at the interface of layers 152 and 156). During use, electrodes 120 and 180 are electrically connected to an external load so that electrons pass from electrode 120 through the external load to electrode 180.

Referring to FIG. 1, recombination material 150 can include a hole block layer 156 and a hole carrier layer 152.

Hole blocking layer 156 is generally formed of a material that, at the thickness used in photovoltaic cell 100, transports electrons to hole carrier layer 152 and substantially blocks the transport of holes to hole carrier layer 152. Hole blocking layer 156 generally includes an n-type semiconductor material and a polyamine.

Examples of suitable n-type semiconductor materials include fullerenes, such as unsubstituted fullerenes or substituted fullerenes. Examples of unsubstituted fullerenes include C₆₀, C₇₀, C₇₆, C₇₈, C₈₂, C₈₄, and C₉₂. Examples of substituted fullerenes include fullerene substituted with phenyl-butyric acid methyl esters (PCBMs, such as phenyl-C61-butyric acid methyl ester (C61-PCBM) or a phenyl-C71-butyric acid methyl ester (C71-PCBM)) or fullerenes substituted with C₁-C₂₀ alkoxy optionally further substituted with C₁-C₂₀ alkoxy and/or halo (e.g., (OCH₂CH₂)₂OCH₃ or OCH₂CF₂OCF₂CF₂OCF₃). Other examples of fullerenes have been described in, e.g., commonly-owned U.S. Patent No. 7,329,709 and International Application No. WO 2011/160021. In certain embodiments, a combination of n-type semiconductor materials can be used in hole blocking layer 156.

In some embodiments, hole blocking layer 156 can include at least about 20 wt% (e.g., at least about 30 wt%, at least about 40 wt%, at least about 50 wt%) and/or at most about 75 wt% (e.g., at most about 70 wt%, at most about 60%, or at most about 50 wt%) of the n-type semiconductor material.

In some embodiments, the n-type semiconductor material (e.g., a substituted fullerene) can be dissolved in the solvent (e.g., a mixture of an alcohol and a chlorinated solvent) used to dissolve other components used to prepare hole blocking layer 156. Without wishing to be bound by theory, it is believed that such an n-type semiconductor material can facilitate formation of a uniform hole blocking layer 156. In addition, without wishing to be bound by theory, it is believed that using such an n-type semiconductor material can facilitate formation of hole blocking layer 156 having a relative large thickness (e.g., from about 30 nm to about 60 nm), while still maintaining the electrical conductivity of layer 156. Layer 156 thus formed can minimize shunting between two neighboring subcells and minimize voltage loss caused by shunting, thereby forming a tandem photovoltaic cell having a voltage output that is generally equal to the sum of the total voltages of the subcells.

As used herein, the term "polyamine" refers to a polymer having two or more amino groups, including primary amino groups, secondary amino groups, and tertiary amino groups. Examples of suitable polyamines in hole blocking layer 156 include polyethylenimines or their copolymers. In certain embodiments, at least some (e.g., substantially all) of the molecules of the polyamine in hole blocking layer 156 can be cross-linked, e.g., via a cross-linking agent. Exemplary cross-linking agents include epoxy-containing compounds, such as glycerol propoxylate triglycidyl ether and glycerol diglycidyl ether. Without wishing to be bound by theory, it is believed that cross-linked the polyamine can result in a cross-linked hole blocking layer 156, which can function as a barrier for the solvent used to prepare photoactive layer 160 to prevent the solvent from reaching the layers (e.g., hole carrier layer 152 or photoactive layer 140) underneath hole blocking layer 156, thereby resulting in shunting between the first and second subcells in photovoltaic cell 100 and/or and disrupting the morphology of photoactive layer 140. In some embodiments, the weight ratio between the polyamine and the cross-linking agent can be between about 1:2 and about 2:1 (e.g., about 1:1).

In some embodiments, hole blocking layer 156 can include at least about 25 wt% (e.g., at least about 30 wt%, at least about 40 wt%, or at least about 50 wt%) and/or at most about 80 wt% (e.g., at most about 70 wt%, at most about 60%, or at most about 50 wt%) of the cross-linked polyamine.

In general, hole blocking layer 156 have a sufficiently large thickness such that it functions as a barrier for the solvent used to prepare photoactive layer 160 on top of layer 156. In some embodiments, hole blocking layer 156 can have a thickness of at least about 20 nm (e.g., at least about 30 nm, at least about 40 nm, or at least about 50 nm) and/or at most about 200 nm (e.g., at most about 150 nm, at most about 100 nm, at most about 80 nm, or at most about 60 nm). Without wishing to be bound by theory, it is believe that, if the thickness of hole blocking layer 156 is too small (e.g., smaller than about 20 nm), shunting between the first and second subcells in photovoltaic cell 100 can occur, which can cause voltage losses to cell 100. Without wishing to be bound by theory, it is believe that, if the thickness of hole blocking layer 156 is too large (e.g., larger than about 200 nm), light absorption by layer 156 may be too high such that the second subcell in photovoltaic cell 100 may not receive enough incident light to generate electricity with a sufficiently high voltage or current.

In some embodiments, hole blocking layer 156 can have a work function of at least about 3.5 eV (e.g., at least about 3.6 eV, at least about 3.8 eV, or at least about 4 eV) and/or at most about 4.5 eV (e.g., at most about 4.4 eV, at most about 4.2 eV, or at most about 4 eV). Without wishing to be bound by theory, it is believed that, when hole blocking layer 156 has a work function ranging from about 3.5 eV to about 4.5 eV, layer 156 can selectively transport electrons to hole carrier layer 152 and substantially block the transport of holes to hole carrier layer 152.

Without wishing to be bound by theory, it is believed that cross-linked hole blocking layer 156 containing an n-type semiconductor material and having a relatively large thickness (e.g., from about 30 nm to about 60 nm) can minimize shunting between two neighboring subcells while maintaining sufficient electrical conductivity between two neighboring subcells. As a result, a tandem photovoltaic cell formed from such a hole blocking layer in a recombination material can have a voltage output that is generally equal to the sum of the total voltages of the subcells.

In some embodiments, hole blocking layer 156 can be prepared by dissolving or dispersing an n-type semiconductor material (e.g., C61-PCBM), a polyamine (e.g., a polyethylenimine), and a cross-linking agent (e.g., glycerol diglycidyl ether) in a suitable solvent to form a composition (e.g., a dispersion or solution) and then coating the composition thus formed on a layer (e.g., hole carrier layer 152) in photovoltaic cell 100 using a liquid-based coating process. In general, solvents suitable for the above process do not dissolve the components in the underlying layer (e.g., hole carrier layer 152) and therefore do not adversely impact that layer. Examples of suitable solvents include chlorinated solvents (e.g., trichloroethylene, methylene chloride, ethylene chloride, tetrachloroethylene,), ethers (diethylether, dimethylether, or tetrahydrofuran), dimethylformamide, dimethyl sulfoxide, or a mixture thereof. In some embodiments, the solvent can be a mixture containing a chlorinated solvent and one or more other solvents (e.g., an alcohol such as methanol, ethanol, propanol, or butanol). In some embodiments, the weight ratio between the amount of the n-type semiconductor material and the combined amount of the polyamine and the cross-linking agent in the above composition can be between about 1:3 and about 3:1 (e.g., about 1:1).

The term "liquid-based coating process" mentioned herein refers to a process that uses a liquid-based coating composition. Examples of the liquid-based coating composition can be a solution, a dispersion, or a suspension. The concentration of a liquid-based coating composition can generally be adjusted as desired. In some embodiments, the concentration can be adjusted to achieve a desired viscosity of the coating composition or a desired thickness of the coating. The liquid-based coating process can be carried out by using at least one of the following processes: solution coating, ink jet printing, spin coating, dip coating, knife coating, bar coating, spray coating, roller coating, slot coating, gravure coating, flexographic printing, or screen printing. Examples of liquid-based coating processes have been described in, for example, commonly-owned co-pending U.S. Application Publication No. 2008-0006324.

Hole carrier layer 152 is generally formed of a material that, at the thickness used in photovoltaic cell 100, transports holes to hole blocking layer 156 and substantially blocks the transport of electrons to hole blocking layer 156. In general, hole carrier layer 152 can include a p-type semiconductor material. Examples of suitable p-type semiconductor materials include polymers and/or metal oxides. Exemplary p-type semiconductor polymers include polythiophenes (e.g., poly(3,4-ethylene dioxythiophene) (PEDOT) or poly(thieno[3,4-b]thiophene)), polyanilines, polycarbazoles, polyvinylcarbazoles, polyphenylenes, polyphenylvinylenes, polysilanes, polythienylenevinylenes, polyisothianaphthanenes, and copolymers thereof. Examples of commercially available polymers that can be used in layer 152 include the Air Products® HIL family of thiophene polymers and H.C. Starck Baytron® family of thiophene polymers. In some embodiments, layer 152 can also include a dopant for the polymer. For example, the dopant can include poly(styrene-sulfonate)s, polystyrene sulfonic acids, or sulfonated tetrafluorethylenes.

Exemplary p-type semiconductor metal oxides include nickel oxides, vanadium oxides, tungsten oxides, molybdenum oxides, copper oxides, strontium copper oxides, and strontium titanium oxides. The metal oxides can be either undoped or doped with a dopant. Examples of dopants for metal oxides include salts or acids of fluoride, chloride, bromide, and iodide. In some embodiments, the hole carrier materials in layer 152 can be in the form of nanoparticles. The nanoparticles can have any suitable shape, such as a spherical, cylindrical, or rod-like shape.

In some embodiments, hole carrier layer 152 can include combinations of the above p-type semiconductor materials. For example, hole carrier layer 152 can include metal oxide nanoparticles dispersed or embedded in a polymer.

In general, the thickness of hole carrier layer 152 (i.e., the distance between the surface of hole carrier layer 152 in contact with photoactive layer 140 and the surface of hole blocking layer 156 in contact with hole carrier layer 152) can be varied as desired. Typically, the thickness of hole carrier layer 152 is at least 0.01 micron (e.g., at least about 0.05 micron, at least about 0.1 micron, at least about 0.2 micron, at least about 0.3 micron, or at least about 0.5 micron) and/or at most about five microns (e.g., at most about three microns, at most about two microns, or at most about one micron). In some embodiments, the thickness of hole carrier layer 152 is from about 0.01 micron to about 0.5 micron (e.g., about 0.1 micron).

In some embodiments, hole carrier layer 152 can have a work function of at least about 4.8 eV (e.g., at least about 5 eV, at least about 5.2 eV, or at least about 5.4 eV) and/or at most about 6.5 eV (e.g., at most about 6.4 eV, at most about 6.2 eV, or at most about 6 eV). Without wishing to be bound by theory, it is believed that, when hole carrier layer 152 has a work function ranging from about 4.8 eV to about 6.5 eV, layer 152 can selectively transport holes to hole blocking layer 156 and substantially block the transport of electrons to hole blocking layer 156.

Turning to other components of photovoltaic cell 100, substrate 110 is generally formed of a transparent material. As referred to herein, a transparent material is a material which, at the thickness used in a photovoltaic cell 100, transmits at least about 60% (e.g., at least about 70%, at least about 75%, at least about 80%, at least about 85%) of incident light at a wavelength or a range of wavelengths used during operation of the photovoltaic cell. Exemplary materials from which substrate 110 can be formed include polyethylene terephthalates, polyimides, polyethylene naphthalates, polymeric hydrocarbons, cellulosic polymers, polycarbonates, polyamides, polyethers, and polyether ketones. In certain embodiments, the polymer can be a fluorinated polymer. In some embodiments, combinations of polymeric materials are used. In certain embodiments, different regions of substrate 110 can be formed of different materials.

In general, substrate 110 can be flexible, semi-rigid or rigid (e.g., glass). In some embodiments, substrate 110 has a flexural modulus of less than about 5,000 megaPascals (e.g., less than about 1,000 megaPascals or less than about 500 megaPascals). In certain embodiments, different regions of substrate 110 can be flexible, semi-rigid, or inflexible (e.g., one or more regions flexible and one or more different regions semi-rigid, one or more regions flexible and one or more different regions inflexible).

Typically, substrate 110 is at least about one micron (e.g., at least about five microns or at least about 10 microns) thick and/or at most about 1,000 microns (e.g., at most about 500 microns thick, at most about 300 microns thick, at most about 200 microns thick, at most about 100 microns, or at most about 50 microns) thick.

Generally, substrate 110 can be colored or non-colored. In some embodiments, one or more portions of substrate 110 is/are colored while one or more different portions of substrate 110 is/are non-colored.

Substrate 110 can have one planar surface (e.g., the surface on which light impinges), two planar surfaces (e.g., the surface on which light impinges and the opposite surface), or no planar surfaces. A non-planar surface of substrate 110 can, for example, be curved or stepped. In some embodiments, a non-planar surface of substrate 110 is patterned (e.g., having patterned steps to form a Fresnel lens, a lenticular lens or a lenticular prism).

Electrode 120 is generally formed of an electrically conductive material. Exemplary electrically conductive materials include electrically conductive metals, electrically conductive alloys, electrically conductive polymers, and electrically conductive metal oxides. Exemplary electrically conductive metals include gold, silver, copper, aluminum, nickel, palladium, platinum, and titanium. Exemplary electrically conductive alloys include stainless steel (e.g., 332 stainless steel, 316 stainless steel), alloys of gold, alloys of silver, alloys of copper, alloys of aluminum, alloys of nickel, alloys of palladium, alloys of platinum, and alloys of titanium. Exemplary electrically conducting polymers include polythiophenes (e.g., doped poly(3,4-ethylenedioxythiophene) (doped PEDOT)), polyanilines (e.g., doped polyanilines), polypyrroles (e.g., doped polypyrroles). Exemplary electrically conducting metal oxides include indium tin oxide, fluorinated tin oxide, tin oxide and zinc oxide. In some embodiments, combinations of electrically conductive materials are used.

In some embodiments, electrode 120 can include a mesh electrode. Examples of mesh electrodes are described in co-pending U.S. Patent Application Publication Nos. 20040187911 and 20060090791.

In some embodiments, a combination of the materials described above can be used to form electrode 120.

Optionally, photovoltaic cell 100 can include a hole blocking layer 130. Hole blocking layer 130 is generally formed of a material that, at the thickness used in photovoltaic cell 100, transports electrons to electrode 120 and substantially blocks the transport of holes to electrode 120. Hole blocking layer 130 can be made from materials different from or the same as the materials used to make hole blocking layer 156. Examples of materials from which hole blocking layer 130 can be formed include LiF, metal oxides (e.g., zinc oxide, titanium oxide), and amines (e.g., primary, secondary, tertiary amines, or polyamines). Examples of amines suitable for use in a hole blocking layer have been described, for example, in co-pending U.S. Application Publication No. 2008-0264488. In some embodiments, hole blocking layer 130 can be formed from the same materials used to prepare hole blocking layer 156 except that layer 130 does not include an n-type semiconductor material (e.g., C61-PCBM).

Without wishing to be bound by theory, it is believed that when photovoltaic cell 100 includes a hole blocking layer made of amines, the hole blocking layer can facilitate the formation of ohmic contact between two neighboring layers (e.g., photoactive layer 140 and electrode 120) without being exposed to UV light, thereby reducing damage to photovoltaic cell 100 resulted from UV exposure.

Typically, hole blocking layer 130 is at least about 1 nm (e.g., at least about 2 nm, at least about 5 nm, at least about 10 nm, at least about 20 nm, at least about 30 nm, or at least about 40 nm) thick and/or at most about 50 nm (e.g., at most about 40 nm, at most about 30 nm, at most about 20 nm, at most about 10 nm, at most about 5 nm, or at most about 2 nm) thick.

In some embodiments, each of photoactive layers 140 and 160 can contain an electron acceptor material (e.g., an organic electron acceptor material) and an electron donor material (e.g., an organic electron donor material).

Examples of electron acceptor materials include fullerenes, inorganic nanoparticles, oxadiazoles, discotic liquid crystals, carbon nanorods, inorganic nanorods, polymers containing moieties capable of accepting electrons or forming stable anions (e.g., polymers containing CN groups or polymers containing CF₃ groups), and combinations thereof. In some embodiments, the electron acceptor material is a substituted fullerene (e.g., a PCBM). In some embodiments, a combination of electron acceptor materials can be used in photoactive layer 140 or 160.

Examples of electron donor materials include conjugated polymers, such as polythiophenes, polyanilines, polycarbazoles, polyvinylcarbazoles, polyphenylenes, polyphenylvinylenes, polysilanes, polythienylenevinylenes, polyisothianaphthanenes, polycyclopentadithiophenes, polysilacyclopentadithiophenes, polycyclopentadithiazoles, polythiazolothiazoles, polythiazoles, polybenzothiadiazoles, poly(thiophene oxide)s, poly(cyclopentadithiophene oxide)s, polythiadiazoloquinoxalines, polybenzoisothiazoles, polybenzothiazoles, polythienothiophenes, poly(thienothiophene oxide)s, polydithienothiophenes, poly(dithienothiophene oxide)s, polytetrahydroisoindoles, polybenzodithiophenes, poly(pyrrolopyrroledione)s, and copolymers thereof. In some embodiments, the electron donor material can be polythiophenes (e.g., poly(3-hexylthiophene)), polycyclopentadithiophenes, and copolymers thereof. In certain embodiments, a combination of electron donor materials can be used in photoactive layer 140 or 160.

Examples of other photoactive polymers suitable for use in photoactive layer 140 or 160 have been described in, e.g., U.S. Patent Nos. 8,058,550, 7,781,673 and 7,772,485, WO 2011/085004, PCT/US2012/035254, and U.S. Application Publication Nos. 2010-0224252, 2010-0032018, 2008-0121281, 2008-0087324, and 2007-0020526.

In some embodiments, photoactive layer 140 can include the same electron donor and acceptor materials as those in photoactive layer 160. In certain embodiments, photoactive layer 140 can include an electron donor or acceptor material that is different from the electron donor or acceptor material in photoactive layer 160.

Optionally, photovoltaic cell 100 can include a hole carrier layer 170. Hole carrier layer 170 is generally formed of a material that, at the thickness used in photovoltaic cell 100, transports holes to electrode 180 and substantially blocks the transport of electrons to electrode 180. In general, hole carrier layer 170 can be made from a p-type semiconductor material, such as one of the p-type semiconductor materials described above with respect to hole carrier layer 152. In some embodiments, hole carrier layer 170 is formed of a combination of p-type semiconductor materials. In some embodiments, hole carrier layer 170 can have substantially the same characteristics or properties as those of hole carrier layer 152. In some embodiments, hole carrier layer 170 can be made from a p-type semiconductor material different from that used in hole carrier layer 152.

Electrode 180 is generally formed of an electrically conductive material, such as one or more of the electrically conductive materials described above with respect to electrode 120. In some embodiments, electrode 180 is formed of a combination of electrically conductive materials. In certain embodiments, electrode 180 can be formed of a mesh electrode. In some embodiments, each of electrodes 120 and 180 can be formed of a mesh electrode described herein.

Substrate 190 can be identical to or different from substrate 110. In some embodiments, substrate 190 can be formed of one or more suitable polymers, such as the polymers used in substrate 110 described above. Substrate 190 can be placed on top of electrode 180 by a method known in the art (e.g., by attaching to electrode 180 using an adhesive).

In some embodiments, a tandem cell can include more than two subcells (e.g., three, four, five, six, seven, eight, nine, ten, or more subcells). In certain embodiments, some subcells can be electrically interconnected in series and some subcells can be electrically interconnected in parallel.

In general, the methods of preparing each layer (e.g., layers 120-180) in photovoltaic cells described in FIG. 1 can vary as desired. In some embodiments, one or more layers (e.g., each layer in photovoltaic cell 100) can be prepared by a liquid-based coating process. In certain embodiments, one or more layers can be prepared via a gas phase-based coating process, such as chemical or physical vapor deposition processes.

In some embodiments, when a layer includes inorganic semiconductor nanoparticles, the liquid-based coating process can be carried out by (1) mixing the nanoparticles with a solvent (e.g., an aqueous solvent or an anhydrous alcohol) to form a dispersion, (2) coating the dispersion onto a substrate, and (3) drying the coated dispersion. In certain embodiments, a liquid-based coating process for preparing a layer containing inorganic metal oxide nanoparticles can be carried out by (1) dispersing a precursor (e.g., a titanium salt) in a suitable solvent (e.g., an anhydrous alcohol) to form a dispersion, (2) coating the dispersion on a substrate, (3) hydrolyzing the dispersion to form an inorganic semiconductor nanoparticles layer (e.g., a titanium oxide nanoparticles layer), and (4) drying the inorganic semiconductor material layer. In certain embodiments, the liquid-based coating process can be carried out by a sol-gel process (e.g., by forming metal oxide nanoparticles as a sol-gel in a dispersion before coating the dispersion on a substrate).

In general, the liquid-based coating process used to prepare a layer containing an organic semiconductor material can be the same as or different from that used to prepare a layer containing an inorganic semiconductor material. In some embodiments, to prepare a layer that includes an organic semiconductor material, the liquid-based coating process can be carried out by mixing the organic semiconductor material with a solvent (e.g., an organic solvent) to form a solution or a dispersion, coating the solution or dispersion on a substrate, and drying the coated solution or dispersion.

In some embodiments, photovoltaic cell 100 can be prepared by a method that includes (1) applying a composition (e.g., a solution or a dispersion) containing an n-type semiconductor material, a polyamine, and a cross-linking agent on a substrate (e.g., substrate 110) to form a layer supported by the substrate; and (2) heating the layer to cross-link at least some molecules of the polyamine, thereby forming a first hole blocking layer (e.g., layer 156). In such embodiments, the method can further include disposing a first electrode (e.g., electrode 120), a first photoactive layer (e.g., layer 140), and a first hole carrier layer (e.g., layer 152) sequentially onto the substrate (e.g., substrate 110) prior to applying the composition to the substrate. In addition, the method can further include disposing a second photoactive layer (e.g., layer 160) and a second electrode (e.g., electrode 180) sequentially onto the first hole blocking layer (e.g., layer 156). In some embodiments, the method can further include disposing a second hole blocking layer (e.g., layer 130) on the first electrode (e.g., electrode 120) prior to disposing the first photoactive layer (e.g., layer 140). In some embodiments, the method can further include disposing a second hole carrier layer (e.g., layer 170) on the second photoactive layer (e.g., layer 160) prior to disposing the second electrode (e.g., electrode 180). In some embodiments, each disposing step described above can be carried out via a liquid-based coating process.

In some embodiments, the tandem photovoltaic cell described in FIG. 1 can be prepared in a continuous manufacturing process, such as a roll-to-roll process, thereby significantly reducing the manufacturing cost. Examples of roll-to-roll processes have been described in, for example, commonly-owned U.S. Patent Nos. 8,129,616 and 7,476,278.

While certain embodiments have been disclosed, other embodiments are also possible.

In some embodiments, photovoltaic cell 100 includes a cathode as a bottom electrode and an anode as a top electrode. In some embodiments, photovoltaic cell 100 can include an anode as a bottom electrode and a cathode as a top electrode.

In some embodiments, photovoltaic cell 100 can include the layers shown in FIG. 1 in a reverse order. In other words, photovoltaic cell 100 can include these layers from the bottom to the top in the following sequence: a substrate 190, an electrode 180, an optional hole carrier layer 170, a photoactive layer 160, a hole blocking layer 156, a hole carrier layer 152, a photoactive layer 140, an optional hole blocking layer 130, an electrode 120, and a substrate 110.

In some embodiments, one of substrates 110 and 190 can be transparent. In other embodiments, both of substrates 110 and 190 can be transparent.

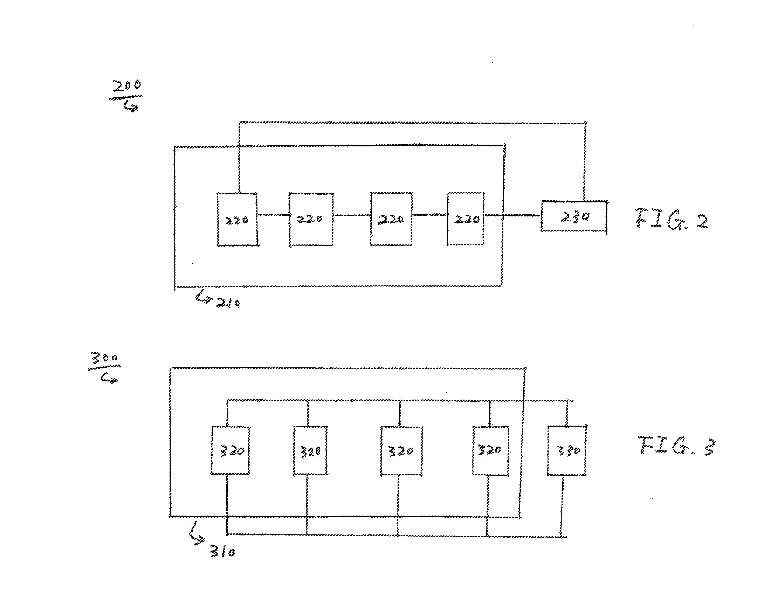

In some embodiments, multiple photovoltaic cells can be electrically connected to form a photovoltaic system. As an example, FIG. 2 is a schematic of a photovoltaic system 200 having a module 210 containing a plurality of photovoltaic cells 220 (e.g., tandem photovoltaic cells). Cells 220 are electrically connected in series, and system 200 is electrically connected to a load 230. As another example, FIG. 3 is a schematic of a photovoltaic system 300 having a module 310 that contains a plurality of photovoltaic cells 320 (e.g., tandem photovoltaic cells). Cells 320 are electrically connected in parallel, and system 300 is electrically connected to a load 330. In some embodiments, some (e.g., all) of the photovoltaic cells (e.g., tandem photovoltaic cells) in a photovoltaic system can be disposed on one or more common substrates. In certain embodiments, some photovoltaic cells (e.g., tandem photovoltaic cells) in a photovoltaic system are electrically connected in series, and some of the photovoltaic cells (e.g., tandem photovoltaic cells) in the photovoltaic system are electrically connected in parallel.

In some embodiments, recombination material 150 can be used in tandem photovoltaic cells other than that described in FIG. 1 above. Other examples of tandem photovoltaic cells have been described in, e.g., commonly-owned co-pending U.S. Application Publication Nos. 2009-0211633, 2007-0272296, 2007-0181179, and 2007-0246094.

While organic tandem photovoltaic cells have been described, other photovoltaic cells can also incorporate recombination material 150 described herein. Examples of such tandem photovoltaic cells include those in which one or more subcells are dye sensitized photovoltaic cells and/or inorganic photoactive cells with a photoactive material formed of amorphous silicon, cadmium selenide, cadmium telluride, copper indium selenide, and copper indium gallium selenide.

While photovoltaic cells have been described above, in some embodiments, recombination material 150 described herein can be used in other devices and systems. For example, recombination material 150 can be used in suitable organic semiconductive devices, such as field effect transistors, photodetectors (e.g., IR detectors), photovoltaic detectors, imaging devices (e.g., RGB imaging devices for cameras or medical imaging systems), light emitting diodes (LEDs) (e.g., organic LEDs (OLEDs) or IR or near IR LEDs), lasing devices, conversion layers (e.g., layers that convert visible emission into IR emission), amplifiers and emitters for telecommunication (e.g., dopants for fibers), storage elements (e.g., holographic storage elements), and electrochromic devices (e.g., electrochromic displays).

The following examples are illustrative and not intended to be limiting.

### Example 1: Fabrication of tandem photovoltaic cells having an interconnecting layer with or without PCBM

Two sets of tandem photovoltaic cells were prepared using the procedures described below.

The first set of four tandem photovoltaic cells were prepared as follows: A transparent conducting oxide (TCO) coated plastic substrate was patterned of to form bottom electrodes and then sonicated for 5 minutes in isopropanol. A thin hole blocking layer is coated on the cleaned substrate using either 1 wt% sol-gel TiO₂ (titanium tetrabutoxide solution in n-butanol) or 0.5 wt% polyethylenimine (PEI) and 0.5 wt% glycerol diglycidyl ether DEG (1:1 weight ratio in butanol). The typical thickness of the hole blocking layer was about 10 nm. The substrate thus formed was annealed at 100°C for 2 minutes. A first photoactive layer including a poly(pyrrolopyrroledione) copolymer (available from Ciba Specialty Chemicals, Basel, Switzerland; referred to hereinafter as "Ciba") and C61-PCBM in 1:2 weight ratio was deposited on the hole blocking layer and its thickness was controlled to achieve a light absorbance of about 0.4 to 0.5. A 100 nm thick hole carrier layer containing a HIL thiophene polymer (Air Products and Chemicals, Inc., Allentown, PA) was deposited on the first photoactive layer using blade coating technique and dried under ambient conditions for a few minutes. A 30 nm thick of a hole blocking layer was formed by applying a solution containing 1 wt% C61-PCBM, 0.5 wt% PEI, and 0.5 wt% DEG in 1/9 butanol/dichloroethylene on top of the hole carrier layer. This hole blocking layer was cross-linked by annealing at 140°C for 10 minutes. A second photoactive layer was then formed by applying a solution containing 1:1 P3HT/PCBM in o-dichlorobenzene on top of the cross-linked hole blocking layer, which was followed by deposition of 50 nm another hole carrier layer of containing the HIL thiophene polymer mentioned above. A double junction tandem cell (i.e., having two subcells) was then formed by evaporation of a silver layer (80 nm) on the hole carrier layer as a top electrode.

A second set of four tandem photovoltaic cells were fabricated using the steps described in the preceding paragraph except that the cross-linked hole blocking layer was replaced with a 20 nm cross-linked hole blocking layer formed from a solution containing 0.5 wt% PEI and 0.5 wt% DEG in n-butanol. The second set of tandem photovoltaic cells were used as a control.

The performance of the tandem photovoltaic cells thus formed was measured using a solar simulator under AM 1.5 conditions. The results are summarized in Table 1.

As shown in Table 1, the first set of tandem cells (which included an interconnecting hole blocking layer containing C61-PCBM) exhibited open circuit Voc of over 1.0 V, which was generally equal to the sum of the voltages of the two subcells (i.e., about 0.6 V for the subcell containing Ciba and about 0.54 V for the subcell containing P3HT). On the other hand, the second set of tandem photovoltaic cells (which included an interconnecting hole blocking layer without C61-PCBM) exhibited Voc of less than 0.5 V, i.e., less than the Voc of each subcell. In addition, the first set of tandem cells exhibited significantly higher efficiencies than the second set of tandem cells.

**Table 1**

| **Tandem Cell No.** | **Jsc (mA/cm²)** | **Voc (V)** | **Fill Factor** | **Efficiency %** |
|---|---|---|---|---|
| Cell 1 - PEI/DEG/PCBM | 5.58 | 1.09 | 0.57 | 3.47 |
| Cell 2 - PEI/DEG/PCBM | 5.57 | 1.10 | 0.59 | 3.60 |
| Cell 3 - PEI/DEG/PCBM | 5.84 | 1.10 | 0.57 | 3.69 |
| Cell 4 - PEI/DEG/PCBM | 5.68 | 1.08 | 0.55 | 3.38 |
| ***Average*** | ***5.67*** | ***1.09*** | ***0.57*** | ***3.54*** |
| | | | | |
| Cell 1 - PEI/DEG | 4.57 | 0.21 | 0.26 | 0.25 |
| Cell 2 - PEI/DEG | 3.04 | 0.49 | 0.34 | 0.51 |
| Cell 3 - PEI/DEG | 3.96 | 0.51 | 0.37 | 0.74 |
| Cell 4 - PEI/DEG | 4.45 | 0.52 | 0.35 | 0.80 |
| ***Average*** | ***4.00*** | ***0.43*** | ***0.33*** | ***0.58*** |

### Example 2: Fabrication of tandem photovoltaic cells with different photoactive polymers

A third set of seven tandem photovoltaic cells were made in the same manner as the first set of tandem photovoltaic cells described in Example 1 except that the first photoactive layer contained a polybenzodithiophene copolymer (available from Polyera Corporation, Skokie, IL; referred to hereinafter as "OPV6") and C61-PCBM in 1:2 weight ratio and the second photoactive layer contained a polythiazolothiazole copolymer KP143 (available from Konarka Technologies, Inc., Lowell, MA) and C61-PCBM in 1:2 weight ratio.

The performance of the third set of tandem photovoltaic cells was measured using a solar simulator under AM 1.5 conditions. The results are summarized in Table 2 below.

**Table 2**

| **Cell No.** | **J (mA/cm²)** | **J_{sc} (mA/cm²)** | **V_{oc} (V)** | **Vₘₐₓ (V)** | **Fill Factor** | **Efficiency (%)** |
|---|---|---|---|---|---|---|
| Cell (1) | 1.36 | 6.61 | 1.44 | 0.98 | 0.55 | 5.24 |
| Cell (2) | 1.32 | 6.44 | 1.43 | 1.01 | 0.57 | 5.28 |
| Cell (3) | 1.32 | 6.44 | 1.42 | 1.01 | 0.58 | 5.30 |
| Cell (4) | 1.28 | 6.23 | 1.41 | 1.04 | 0.59 | 5.21 |
| Cell (5) | 1.48 | 7.20 | 1.42 | 1.06 | 0.60 | 6.10 |
| Cell (6) | 1.48 | 7.21 | 1.41 | 1.05 | 0.60 | 6.13 |
| Cell (7) | 1.39 | 6.78 | 1.40 | 1.05 | 0.60 | 5.71 |
| **Average** | **1.37** | **6.70** | **1.42** | **1.03** | **0.58** | **5.57** |

As shown in Table 2, all seven tandem photovoltaic cells exhibited high V_{oc} and efficiencies. In particular, each of the seven tandem photovoltaic cells exhibited V_{oc} that was generally equal to the sum of the V_{oc} values of the two subcells (i.e., about 0.66 V for the subcell containing OPV6 and about 0.78 V for the subcell containing KP143) in the tandem cells.

### Example 3: Fabrication of tandem photovoltaic cells having two, three, four, and five subcells

A fourth set of tandem photovoltaic cells containing two subcells, three subcells, four subcells, and five subcells were prepared as follows:
The tandem cells containing two subcells were prepared in the same manner as the first set of tandem cells described in Example 1 except that the first photoactive layer was formed by using a 1 wt% solution of OPV6 and C61-PCBM in a 1:2 weight ratio in o-dichlorobenzene (ODCB) at a blade speed of 5 mm/sec at 65°C and the second photoactive layer was formed by using a 1 wt% solution of OPV6 and C61-PCBM in a 1:2 weight ratio in ODCB at a blade speed of 7.5 mm/sec at 65°C.

The tandem cells containing three subcells were prepared in the same manner as those described in the preceding paragraph except that, prior to forming a silver top electrode, a cross-linked hole blocking layer, a third photoactive layer, and a hole carrier layer were sequentially formed. The cross-linked hole blocking layer and the hole carrier layer were formed in the same manner as those in the first set of tandem cells described in Example 1. The third photoactive layer was formed by using a 1 wt% solution of OPV6 and C61-PCBM in a 1:2 weight ratio in ODCB at a blade speed of 10 mm/sec at 65°C.

The tandem cells containing four subcells were prepared in the same manner as those described in the preceding paragraph except that, prior to forming a silver top electrode, a cross-linked hole blocking layer, a fouth photoactive layer, and a hole carrier layer were sequentially formed. The cross-linked hole blocking layer and the hole carrier layer were formed in the same manner as those in the first set of tandem cells described in Example 1. The fourth photoactive layer was formed by using a 1 wt% solution of OPV6 and C61-PCBM in a 1:2 weight ratio in ODCB at a blade speed of 15 mm/sec at 65°C.

The tandem cells containing five subcells were prepared in the same manner as those described in the preceding paragraph except that, prior to forming a silver top electrode, a cross-linked hole blocking layer, a fifth photoactive layer, and a hole carrier layer were sequentially formed. The cross-linked hole blocking layer and the hole carrier layer were formed in the same manner as those in the first set of tandem cells described in Example 1. The fifth photoactive layer was formed by using a 1 wt% solution of OPV6 and C61-PCBM in a 1:2 weight ratio in ODCB at a blade speed of 30 mm/sec at 65°C.

The performance of the photovoltaic cells formed above was measured using a solar simulator under AM 1.5 conditions. The results are summarized in Table 3. The values listed in Table 3 are average results based on measurements from 5 cells.

**Table 3**

| Solar cell type | J_{sc} (mA/cm²) | V_{oc} (e) | Vₘₐₓ (V) | Fill Factor | Efficiency (%) |
|---|---|---|---|---|---|
| Single junction (one cell) | 4.47 | 0.65 | 0.51 | 0.61 | 1.79 |
| 2-junction tandem (two subcells) | 2.59 | 1.29 | 1.06 | 0.61 | 2.06 |
| 3 junction tandem (three subcells) | 1.63 | 1.96 | 1.6 | 0.63 | 2 |
| 4-junction tandem (four subcells) | 1.66 | 2.58 | 2.08 | 0.61 | 2.6 |
| 5-junction tandem (five subcells) | 0.75 | 3.15 | 2.69 | 0.68 | 1.62 |

As shown in Table 3, the tandem photovoltaic cells containing two, three, four, and five subcells formed above exhibited V_{oc} values that were generally equal to the sum of V_{oc} of the subcells (i.e., 0.65 V for each subcell), respectively.

### Example 4: Stability of tandem photovoltaic cells

A set of tandem photovoltaic cells made in the same manner as the first set of tandem photovoltaic cells described in Example 1 were packaged using a proprietary plastic packaging techniques developed by Konarka Technologies, Inc. The packaged cells were tested using accelerated ageing processes under light soaking conditions (using AM 1.5 conditions) and damp heat ageing conditions (65°C and 85% relative humidity).

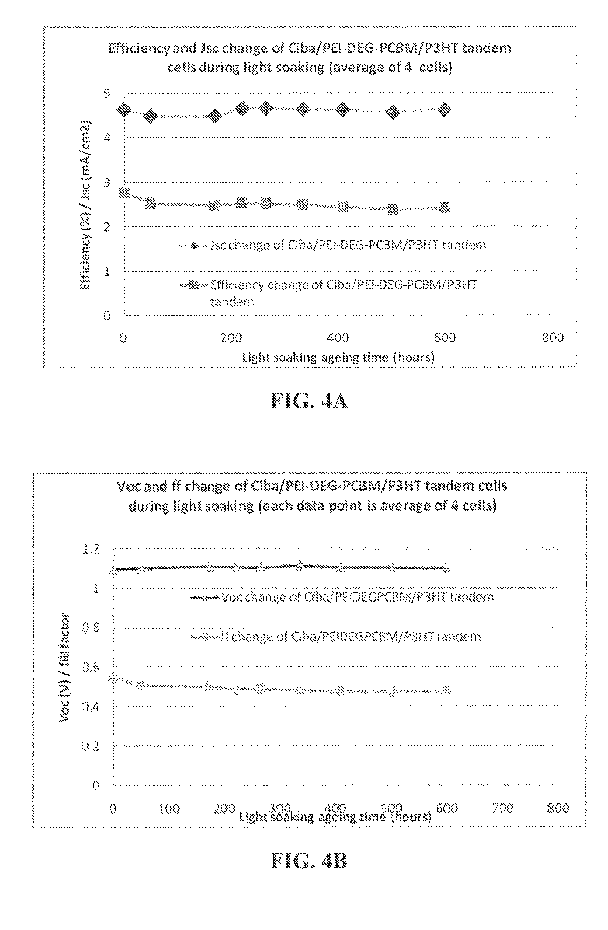

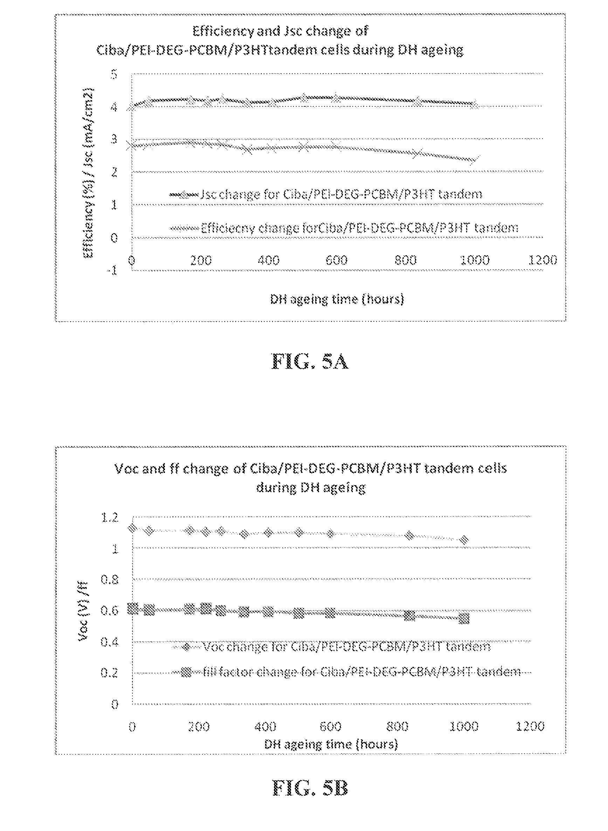

The results of the above tests are shown in FIGs. 4A, 4B, 5A, and 5B. As shown in these figures, the tandem cells made above exhibited remarkable stability under both light soaking conditions and damp heat ageing conditions.

### Example 5: Comparison of stability of tandem photovoltaic cells containing thin and thick interconnecting hole blocking layers

Eight tandem photovoltaic cells were made in the same manner as the first set of tandem photovoltaic cells described in Example 1 except that tandem cells (1)-(4) included an interconnecting hole blocking layer containing C61-PCBM/PEI/DEG and having a thickness of 15 nm and tandem cells (5)-(8) included an interconnecting hole blocking layer containing C61-PCBM/PEI/DEG and having a thickness of 60 nm. In each of these tandem cells, the first photoactive layer contained OPV6/C61-PCBM and the second photoactive layer contained P3HT/C61-PCBM. The cells were packaged using proprietary plastic packaging techniques developed by Konarka Technologies, Inc. The packaged cells were tested under damp heat ageing conditions (65°C and 85% relative humidity) for 120 hours. The results are summarized in Table 4.

**Table 4**

| **Tandem Cell No.** | **Testing conditions** | **J_{sc} (mA/cm²)** | **V_{oc} (V)** | **fill factor** | **Efficiency (%)** |
|---|---|---|---|---|---|
| Cells (1)-(4) | 0 h | 3.69 | 1.20 | 0.59 | 2.60 |
| | 120 h damp heat aged | 2.29 | 0.96 | 0.39 | 0.85 |
| | **% change** | **-37.87** | **-19.79** | **-33.76** | **-67.15** |
| | | | | | |
| Cell (5)-(8) | 0 h | 3.82 | 1.14 | 0.54 | 2.34 |
| | 120 h damp heat aged | 3.83 | 1.13 | 0.56 | 2.43 |
| | **% change** | **0.14** | **-0.22** | **3.70** | **3.63** |

As shown in Table 4, tandem cells (1)-(4) (which contained an interconnecting hole blocking layer having a thickness of 15 nm) exhibited significant reduction in V_{oc}, J_{sc}, and fill factor after the above damp heat ageing process. By contrast, tandem cells (5)-(8) (which contained an interconnecting hole blocking layer having a thickness of 60 nm) essentially maintained the same V_{oc}, J_{sc}, and fill factor after the above damp heat ageing process.

### Example 6: Fabrication of a tandem photovoltaic module containing 10 serially interconnected tandem cells using a roll-to-roll process

A tandem photovoltaic module was prepared in a manner similar to the tandem cells prepared in Example 1 in a continuous roll-to-roll process except that the photovoltaic module contained 10 serially interconnected tandem cells, each of which included two subcells. All layers except the silver top electrode were deposited using procedures described in Example 1. A printed silver layer was deposited as a top electrode using a nanosilver based ink. All of the adjacent tandem cells were serially interconnected on the roll-to-roll coater.

The results showed that the tandem photovoltaic module thus formed exhibited a V_{oc} of 10.55 V, a J_{sc} of 3.13 mA/cm², a fill factor of 55.6%, and an efficiency of 1.84%. In particular, the V_{oc} of the tandem photovoltaic module is generally equal to the sum of the V_{oc} of each tandem cell (i.e., about 1.1 V), which suggested that the 10 tandem cells were interconnected in series with minimal voltage loss.

Other embodiments are within the scope of the following claims.

## Claims

1. A system (100), comprising:
first and second electrodes (120, 180);
first and second photoactive layers (140, 160) between the first and second electrodes (120, 180); and
a recombination material (150) between the first and second photoactive layers (140, 160), the first photoactive layer (140) being between the first electrode (120) and the recombination material (150), and the second photoactive layer (160) being between the second electrode (180) and the recombination material (150);
wherein
the recombination material (150) comprises a first hole blocking layer (156) and a first hole carrier layer (152); the system is configured as a photovoltaic system; and is
**characterized in that**
the first hole blocking layer (156) comprises an n-type semiconductor material and a polyamine, at least some molecules of the polyamine being cross-linked;

2. The system of claim 1, wherein the n-type semiconductor material comprises a fullerene.

3. The system of claim 2, wherein the fullerene is a substituted fullerene.

4. The system of claim 3, wherein the substituted fullerene is C61-PCBM or C71-PCBM.

5. The system of any of claims 1-4, wherein the polyamine is a polyethylenimine or a copolymer thereof.

6. The system of any of claims 1-5, wherein at least some molecules of the polyamine are cross-linked by a cross-linking agent.

7. The system of claim 6, wherein the cross-linking agent comprises an epoxy-containing compound.

8. The system of claim 7, wherein the cross-linking agent comprises glycerol propoxylate triglycidyl ether or glycerol diglycidyl ether.

9. The system of any of claims 1-8, wherein the first hole blocking layer (156) has a thickness of from 20 nm to 200 nm.

10. The system of claim 9, wherein first hole blocking layer (156) has a thickness of from 30 nm to 60 nm.

11. The system of any of claims 1-10, wherein the first hole blocking layer (156) has a work function of from 3.5 eV to 4.5 eV.

12. The system of any of claims 1-11, wherein the first hole carrier layer (156) comprises a p-type semiconductor material.

13. The system of claim 12, wherein the p-type semiconductor material comprises a polymer.

14. The system of claim 13, wherein the polymer is selected from the group consisting of polythiophenes, polyanilines, polycarbazoles, polyvinylcarbazoles, polyphenylenes, polyphenylvinylenes, polysilanes, polythienylenevinylenes, polyisothianaphthanenes, and copolymers thereof.

15. The system of claim 14, wherein the polymer comprises poly(3,4-ethylene dioxythiophene) or poly(thieno[3,4-b]thiophene).

16. The system of claim 12, wherein p-type semiconductor material comprises a metal oxide.

17. The system of claim 16, wherein the metal oxide comprises an oxide selected from the group consisting of nickel oxides, vanadium oxides, tungsten oxides, molybdenum oxides, copper oxides, strontium copper oxides, and strontium titanium oxides.

18. The system of claim 12, wherein the p-type semiconductor material comprises a metal oxide dispersed in a polymer.

19. The system of any of claims 1-18, wherein the first hole carrier layer (152) has a work function of from 4.8 eV to 6.5 eV.

20. The system of any of claims 1-19, further comprising a second hole blocking layer (130) between the first electrode (120) and the first photoactive layer (140), wherein the first photoactive layer (140) is between the second hole blocking (130) layer and the first hole carrier layer (152).

21. The system of claim 20, wherein the second hole blocking layer (130) is made from a material different from that used to make the first hole blocking layer (156).

22. The system of claim 20 or 21, wherein the second hole blocking layer (130) comprises LiF, metal oxides, or amines.

23. The system of any of claims 1-22, further comprising a second hole carrier layer (170) between the second electrode (180) and the second photoactive layer (160), wherein the second photoactive layer (160) is between the first hole blocking layer (156) and the second hole carrier layer (170).

24. The system of claim 23, wherein the second hole carrier layer (170) comprises a polymer selected from the group consisting of polythiophenes, polyanilines, polycarbazoles, polyvinylcarbazoles, polyphenylenes, polyphenylvinylenes, polysilanes, polythienylenevinylenes, polyisothianaphthanenes, and copolymers or mixtures thereof.

25. The system of any of claims 1-24, wherein the system is configured as a tandem photovoltaic system.

## Patentansprüche

1. System (100), enthaltend:
erste und zweite Elektroden (120, 180);
erste und zweite photoaktive Schichten (140, 160) zwischen den ersten und zweiten Elektroden (120, 180); und
ein Rekombinationsmaterial (150) zwischen den ersten und zweiten photoaktiven Schichten (140, 160), wobei sich die erste photoaktive Schicht (140) zwischen der ersten Elektrode (120) und dem Rekombinationsmaterial (150) befindet und die zweite photoaktive Schicht (160) sich zwischen der zweiten Elektrode (180) und dem Rekombinationsmaterial (150) befindet;
wobei
das Rekombinationsmaterial (150) eine erste Lochblockierungsschicht (156) und eine erste Lochträgerschicht (152) enthält;
das System als photovoltaisches System konfiguriert ist; und
**dadurch gekennzeichnet ist, dass**
die erste Lochblockierungsschicht (156) ein Halbleitermaterial des n-Typs und ein Polyamin enthält, wobei mindestens einige Moleküle des Polyamins vernetzt sind.

2. System nach Anspruch 1, wobei das Halbleitermaterial des n-Typs ein Fulleren enthält.

3. System nach Anspruch 2, wobei es sich bei dem Fulleren um ein substituiertes Fulleren handelt.

4. System nach Anspruch 3, wobei es sich bei dem substituierten Fulleren um C61-PCBM oder C71-PCBM handelt.

5. System nach einem beliebigen der Ansprüche 1-4, wobei es sich bei dem Polyamin um ein Polyethylenimin oder ein Copolymer davon handelt.

6. System nach einem beliebigen der Ansprüche 1-5, wobei mindestens einige Moleküle des Polyamins durch ein Vernetzungsmittel vernetzt sind.

7. System nach Anspruch 6, wobei das Vernetzungsmittel eine epoxyhaltige Verbindung enthält.

8. System nach Anspruch 7, wobei das Vernetzungsmittel Glycerinpropoxylattriglycidylether oder Glycerindiglycidylether enthält.

9. System nach einem beliebigen der Ansprüche 1-8, wobei die erste Lochblockierungsschicht (156) eine Dicke von 20 nm bis 200 nm aufweist.

10. System nach Anspruch 9, wobei die erste Lochblockierungsschicht (156) eine Dicke von 30 nm bis 60 nm aufweist.

11. System nach einem beliebigen der Ansprüche 1-10, wobei die erste Lochblockierungsschicht (156) eine Austrittsarbeit von 3,5 eV bis 4,5 eV besitzt.

12. System nach einem beliebigen der Ansprüche 1-11, wobei die erste Lochträgerschicht (156) ein Halbleitermaterial des p-Typs enthält.

13. System nach Anspruch 12, wobei das Halbleitermaterial des p-Typs ein Polymer enthält.

14. System nach Anspruch 13, wobei das Polymer aus der Gruppe ausgewählt ist, die aus Polythiophenen, Polyanilinen, Polycarbazolen, Polyvinylcarbazolen, Polyphenylenen, Polyphenylvinylenen, Polysilanen, Polythienylenvinylenen, Polyisothianaphthanenen und deren Copolymeren besteht.

15. System nach Anspruch 14, wobei das Polymer Poly(3,4-ethylendioxythiophen) oder Poly(thieno[3,4-b]thiophen) enthält.

16. System nach Anspruch 12, wobei das Halbleitermaterial des p-Typs ein Metalloxid enthält.

17. System nach Anspruch 16, wobei das Metalloxid ein Oxid enthält, das aus der Gruppe ausgewählt ist, die aus Nickeloxiden, Vanadiumoxiden, Wolframoxiden, Molybdänoxiden, Kupferoxiden, Strontium-Kupfer-Oxiden und Strontium-Titan-Oxiden besteht.

18. System nach Anspruch 12, wobei das Halbleitermaterial des p-Typs ein in einem Polymer dispergiertes Metalloxid enthält.

19. System nach einem beliebigen der Ansprüche 1-18, wobei die erste Lochträgerschicht (152) eine Austrittsarbeit von 4,8 eV bis 6,5 eV besitzt.

20. System nach einem beliebigen der Ansprüche 1-19, weiterhin enthaltend eine zweite Lochblockierungsschicht (130) zwischen der ersten Elektrode (120) und der ersten photoaktiven Schicht (140), wobei sich die erste photoaktive Schicht (140) zwischen der zweiten Lockblockierungsschicht (130) und der ersten Lochträgerschicht (152) befindet.

21. System nach Anspruch 20, wobei die zweite Lochblockierungsschicht (130) aus einem Material hergestellt ist, das von dem zur Herstellung der ersten Lochblockierungsschicht (156) verwendeten verschieden ist.

22. System nach Anspruch 20 oder 21, wobei die zweite Lochblockierungsschicht (130) LiF, Metalloxide oder Amine enthält.

23. System nach einem beliebigen der Ansprüche 1-22, weiterhin enthaltend eine zweite Lochträgerschicht (170) zwischen der zweiten Elektrode (180) und der zweiten photoaktiven Schicht (160), wobei sich die zweite photoaktive Schicht (160) zwischen der ersten Lochblockierungsschicht (156) und der zweiten Lochträgerschicht (170) befindet.

24. System nach Anspruch 23, wobei die zweite Lochträgerschicht (170) ein Polymer enthält, das aus der Gruppe ausgewählt ist, die aus Polythiophenen, Polyanilinen, Polycarbazolen, Polyvinylcarbazolen, Polyphenylenen, Polyphenylvinylenen, Polysilanen, Polythienylenvinylenen, Polyisothianaphthanenen und deren Copolymeren oder Mischungen besteht.

25. System nach einem beliebigen der Ansprüche 1-24, wobei das System als photovoltaisches Tandem-System konfiguriert ist.

## Revendications

1. Système (100), comprenant :
des première et seconde électrodes (120, 180) ;
des première et seconde couches photo-actives (140, 160) entre les première et seconde électrodes (120, 180) ; et
un matériau de recombinaison (150) entre les première et seconde couches photo-actives (140, 160), la première couche photo-active (140) étant entre la première électrode (120) et le matériau de recombinaison (150), et la seconde couche photo-active (160) étant entre la seconde électrode (180) et le matériau de recombinaison (150) ; dans lequel :
le matériau de recombinaison (150) comprend une première couche de blocage de trous (156) et une première couche de transport de trous (152) ;
le système est configuré en tant que système photovoltaïque ; et est **caractérisé en ce que** :
la première couche de blocage de trous (156) comprend un matériau semiconducteur de type n et un polyamide, au moins certaines molécules du polyamide étant réticulées.

2. Système selon la revendication 1, dans lequel le matériau semiconducteur de type n comprend un fullerène.

3. Système selon la revendication 2, dans lequel le fullerène est un fullerène substitué.

4. Système selon la revendication 3, dans lequel le fullerène substitué est C61-PCBM ou C71-PCBM.

5. Système selon l'une quelconque des revendications 1-4, dans lequel le polyamine est un polyéthylenimine ou un copolymère afférent.

6. Système selon l'une quelconque des revendications 1-5, dans lequel au moins certaines molécules du polyamine sont réticulées par un agent de réticulation.

7. Système selon la revendication 6, dans lequel l'agent de réticulation comprend un composé contenant un époxy.

8. Système selon la revendication 7, dans lequel l'agent de réticulation comprend du glycérol propoxylate triglycidyl éther ou du glycérol diglycidyl éther.

9. Système selon l'une quelconque des revendications 1-8, dans lequel la première couche de blocage de trous (156) présente une épaisseur qui va de 20 nm à 200 nm.

10. Système selon la revendication 9, dans lequel la première couche de blocage de trous (156) présente une épaisseur qui va de 30 nm à 60 nm.

11. Système selon l'une quelconque des revendications 1-10, dans lequel la première couche de blocage de trous (156) présente une fonction de travail qui va de 3,5 eV à 4,5 eV.

12. Système selon l'une quelconque des revendications 1-11, dans lequel la première couche de blocage de trous (156) comprend un matériau semiconducteur de type p.

13. Système selon la revendication 12, dans lequel le matériau semiconducteur de type p comprend un polymère.

14. Système selon la revendication 13, dans lequel le polymère est choisi parmi le groupe constitué par polythiophènes, polyanilines, polycarbazoles, polyvinylcarbazoles, polyphénylènes, polyphénylvinylènes, polysilanes, polythiénylènevinylènes, polyisothianaphtalènes et leurs copolymères.

15. Système selon la revendication 14, dans lequel le polymère comprend du poly(3,4-éthylène dioxythiophène) ou du poly(thiéno[3,4-b]thiophène).

16. Système selon la revendication 12, dans lequel le matériau semiconducteur de type p comprend un oxyde de métal.

17. Système selon la revendication 16, dans lequel l'oxyde de métal comprend un oxyde choisi parmi le groupe constitué par oxydes de nickel, oxydes de vanadium, oxydes de tungstène, oxydes de molybdène, oxydes de cuivre, oxydes de cuivre et strontium et oxyde de titane et strontium.

18. Système selon la revendication 12, dans lequel le matériau semiconducteur de type p comprend un oxyde de métal dispersé dans un polymère.

19. Système selon l'une quelconque des revendications 1-18, dans lequel la première couche de transport de trous (152) présente une fonction de travail qui va de 4,8 eV à 6,5 eV.

20. Système selon l'une quelconque des revendications 1-19, comprenant en outre une seconde couche de blocage de trous (130) entre la première électrode (120) et la première couche photo-active (140), dans lequel la première couche photo-active (140) est entre la seconde couche de blocage de trous (130) et la première couche de transport de trous (152).

21. Système selon la revendication 20, dans lequel la seconde couche de blocage de trous (130) est réalisée en un matériau différent de celui qui est utilisé pour fabriquer la première couche de blocage de trous (156).

22. Système selon la revendication 20 ou 21, dans lequel la seconde couche de blocage de trous (130) comprend LiF, des oxydes de métal ou des amines.

23. Système selon l'une quelconque des revendications 1-22, comprenant en outre une seconde couche de transport de trous (170) entre la seconde électrode (180) et la seconde couche photo-active (160), dans lequel la seconde couche photo-active (160) est entre la première couche de blocage de trous (156) et la seconde couche de transport de trous (170).

24. Système selon la revendication 23, dans lequel la seconde couche de transport de trous (170) comprend un polymère choisi parmi le groupe comprenant polythiophènes, polyanilines, polycarbazoles, polyvinylcarbazoles, polyphénylènes, polyphénylvinylènes, polysilanes, polythiénylènevinylènes, polyisothianaphtalènes et leurs copolymères ou mélanges.

25. Système selon l'une quelconque des revendications 1-24, dans lequel le système est configuré en tant que système photovoltaïque en tandem.
